# EUROPÄISCHE PATENTSCHRIFT

(11) **EP 0 662 356 B1**
(45) Veröffentlichungstag und Bekanntmachung des Hinweises auf die Patenterteilung: **07.04.1999**
(21) Anmeldenummer: 95100122.1
(22) Anmeldetag: 05.01.1995
(51) Int. Cl.: B06B 1/02, B23K 20/10

(54) **Verfahren und Einrichtung zum Betrieb eines Generators zur HF-Energieversorgung eines Ultraschallwandlers**
Generator driving method and means for the HF-energy supply of an ultrasound transducer
Procédé et dispositif d'entraînement d'un générateur pour l'alimentation d'énergie HF d'un transducteur à ultrason

(30) Priorität: 05.01.1994 DE 4400210
(43) Veröffentlichungstag der Anmeldung: 12.07.1995
(73) Patentinhaber: BRANSON ULTRASCHALL Niederlassung der EMERSON TECHNOLOGIES GmbH & CO., D-63128 Dietzenbach (DE)
(72) Erfinder: Kising, Jürgen, D-63864 Glattbach (DE); Reitmayer, Gerd, D-63743 Aschaffenburg (DE); Modric, Mato, HR-52210 Rovinj (HR)
(74) Vertreter: Wehnert, Werner, Dipl.-Ing. Patentanwälte Hauck, Graalfs, Wehnert, Döring, Siemons

(56) Entgegenhaltungen:
- EP-A- 0 217 694
- EP-A- 0 246 528
- EP-A- 0 247 752
- EP-A- 0 270 819
- EP-A- 0 359 217
- US-A- 4 275 363
- US-A- 4 808 948
- US-A- 5 026 387

## Beschreibung

Die Erfindung betrifft ein Verfahren zum Betrieb eines Generators zur HF-Energieversorgung eines Ultraschallwandlers gemäß dem Oberbegriff des Patentanspruchs 1.

US-PS 4,275,363, von der im Oberbegriff ausgegangen wurde, beschreibt ein Verfahren zum Betrieb eines Generators zur HF-Energieversorgung eines Ultraschallwandlers, bei dem Ultraschallschwingungen nur innerhalb eines verhältnismäßig engen Frequenzbereiches abgegeben werden, in dem ein Resonanzpunkt liegt. Vor Arbeitsbeginn wird die Frequenz, ausgehend von einer tiefen Frequenz, so lange erhöht, bis ein Resonanzpunkt festgestellt wird. Sobald dieser Resonanzpunkt festgestellt ist, wird der Ultraschallwandler auf diese Frequenz eingestellt. EP 217 694 betrifft den Frequenzabgleich für einen Ultraschallwandler, wobei die Serien- bzw. Parallelresonanzfrequenz am Wandler festgestellt werden.

Der Erfindung liegt die Aufgabe zugrunde, ein Verfahren anzugeben, mit dem Ziel, auch bei komplexen Systemen die Frequenz des Generators für den gewünschten Resonanzzustand schneller und zuverlässiger aufzufinden und einzuregeln, die Regelung zu verbessern, zu stabilisieren und eine optimale Anpassung an das Ultraschallsystem zu erzielen.

Die genannte Aufgabe wird mit den Merkmalen des Patentanspruchs 1 gelöst. Vorteilhafte Weiterbildungen und weitere Einzelheiten von erfindungswesentlicher Bedeutung finden sich in den Unteransprüchen.

Erfindungsgemäß liefert die Messung des Stromverlaufes über die Frequenz im Leerlauf dem Microcontroller die Information über die Lage der Resonanzpunkte und eventuell vorhandener Nebenresonanzen. Er kann dann den Tune-Bereich so gestalten und legen, daß eine manuelle Einstellung entfällt. Die Auffindung des richtigen Arbeitspunktes und die optimale Nachregelung ist deshalb ein zentrales Thema der Erfindung. Somit kann der richtige Resonanzpunkt schneller und zuverlässiger aufgefunden und der Betrieb früher begonnen werden.

Für die Frequenzregelung des Generators werden nicht nur der Phasenwinkel, sondern zusätzliche Regelgrößen wie Strom, Spannung, Schein- und Wirkleistung verwendet. Die Verarbeitung und Verknüpfung dieser Werte erfolgt digital in einem Microcontroller, der durch seine Leistungsfähigkeit in der Lage ist, mehrere Parameter zusätzlich zum Phasenwinkel zu registrieren, auszuwerten und hieraus die richtige Regelgröße zur Ansteuerung des Generators zu bilden. So ist die Wahl der geeigneten Parameter und der zulässigen Parameterbereiche, sowie die Anpassung der Meßauflösung an die akkustischen Gegebenheiten des Systems von zentraler Bedeutung für die optimale Frequenzregelung und -nachführung. Allein die Verknüpfung mehrerer Meßwerte versetzt die Regelung in die Lage, den gewünschten Resonanzzustand optimal aufzufinden und einzuregeln, und damit das Anregen von nicht erwünschten Nebenresonanzen zu vermeiden.

Die physikalisch richtige Regelung ist deshalb eine Regelung, die die Phase als Regelgröße oder Kombinationen der Phase mit anderen Regelgrößen wie Scheinleistung, Strom etc. nutzt.

Die digitale Phasenregelung ist auch in der Lage, Systeme auszuregeln, die keinen Phasennulldurchgang besitzen, wodurch sich ein weiteres Anwendungsgebiet als bei der analogen Phasenregelung ergibt. In diesem Fall wird auf das Phasenminimum geregelt oder durch einen Phasenoffset ein Phasennulldurchgang simuliert.

Ein Ausführungsbeispiel der Erfindung ist nachstehend anhand der Zeichnung näher erläutert. Es zeigt:
Fig. 1 eine Gesamtübersicht des digitalen Generators,
Fig. 2 ein Blockschaltbild des Hauptnetzteils,
Fig. 3 ein Blockschaltbild der Endstufe,
Fig. 4 ein Blockschaltbild der Anpassungsstufe,
Fig. 5 ein Blockschaltbild des Microcontrollers, und
Fig. 6 den Stromverlauf, den Impendanzverlauf und den Phasenwinkelverlauf, abhängig von der Frequenz des Generators.

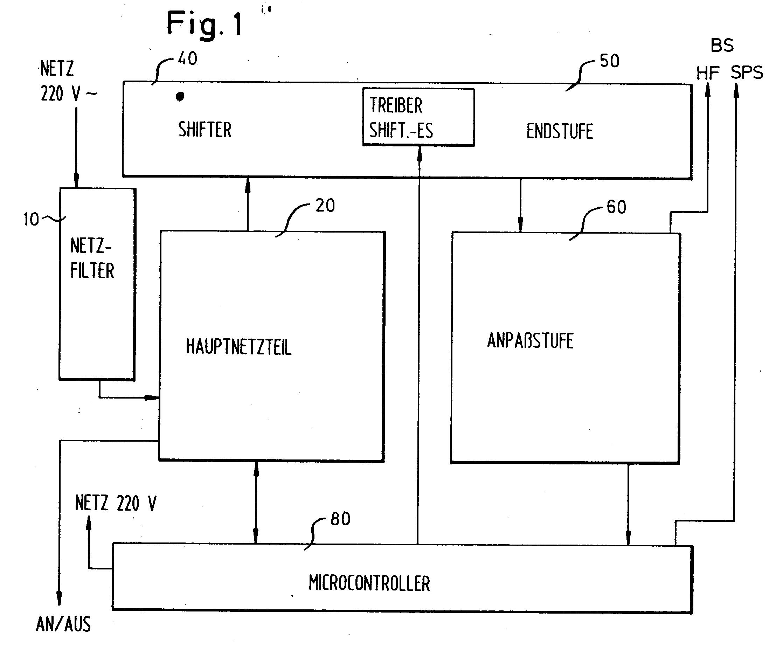

Fig. 1 zeigt die Gesamtübersicht des digitalen Generators. Er besteht im wesentlichen aus fünf Baugruppen:
Dem Netzfilter 10 zum Schutz des Netzes vor hochfrequenten Störungen;
dem Hauptnetzteil 20 zur Spannungsversorgung der einzelnen Komponenten
der Endstufe 50 mit Shifter 40 zur Erzeugung einer vom Microcontroller festgelegten Ausgangsleistung und Ausgangsfrequenz;
der Anpaßstufe 60 zur Anpassung an die Impedanz des Ultraschallwandlers;
dem Microcontroller 80 zur Steuerung des Schweißprozesses und Überwachung der Generatorelektronik.

Die Netzspannung wird über das Netzfilter 10 zum Hauptnetzteil 20 geführt. Das Hauptnetzteil 20 liefert die Versorgungsspannung von 300 V an den Shifter 40 und teilt dem Microcontroller 80 seinen Einschaltzustand mit, damit die Endstufe 50 erst dann vom Microcontroller 80 aktiviert wird, wenn alle Komponenten ihre Betriebsspannung aufgebaut haben. Erst dann ist ein definierter Zustand erreicht, der dem Microcontroller die Steuerung des Generators ermöglicht.

Bei dem Shifter 40 handelt es sich um einen Zerhacker, in dem die vom Hauptnetzteil 20 her anstehenden Gleichspannung in eine Impulsfrequenzfolge umgeformt wird, in der die Impulsbreite die Ausgangsamplitude bestimmt.

Der Shifter 40 bereitet die Gleichspannung und damit die Leistung vor, die von der Endstufe 50 durchgeschaltet wird. Die Leistungshöhe wird vom Microcontroller durch Modulation der vom Shifter erzeugten Pulsweite festgelegt.

Der Ausgang der Endstufe wird schließlich über die Anpassungsstufe 60 dem Wandlersystem impedanzmäßig angepaßt. Bei dem Wandlersystem handelt es sich um einen nicht dargestellten Ultraschallwandler in Verbindung mit einem Amplitudentransformator bzw. einer Sonotrode. Die Ausgangsstufe 50 gibt die Information über die abgegebene Leistung und die Schwingfrequenz wieder an den Microcontroller 80 zurück. Der Microcontroller selbst hat die Aufgabe, aus der ihm zugeführten Information über Strom und Spannung vom Ausgang der Anpaßstufe 60 den optimalen Arbeitspunkt zu finden und die Energie in den Schweißprozeß einzuleiten. Weiterhin kontrolliert der Microcontroller den Einschaltzustand und die zulässigen Ströme in den unterschiedlichen Komponenten.

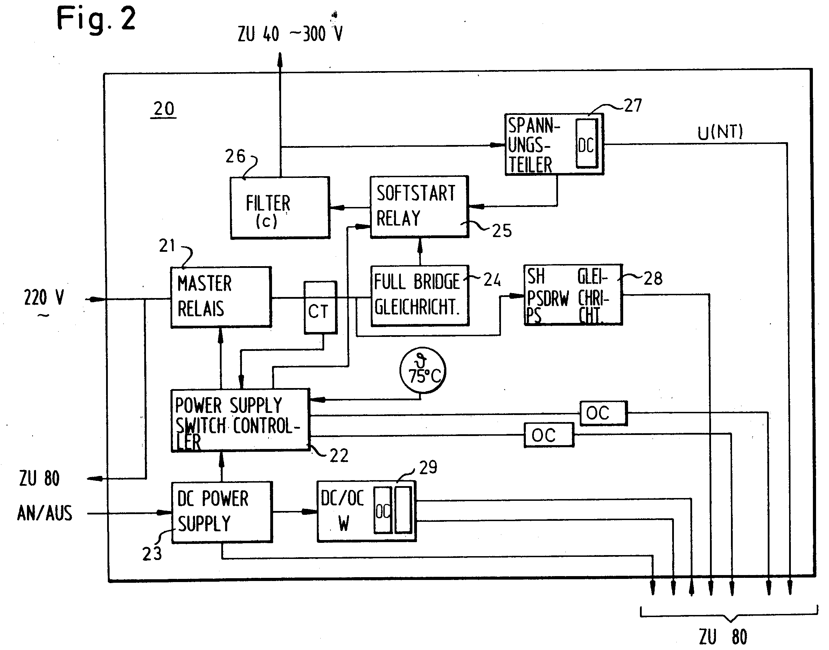

Fig. 2 zeigt den schematischen Aufbau des Hauptnetzteils 20. Ein Master-Relay 21 ermöglicht das vollständige Trennen des Hauptnetzteils vom Netz. Das geschieht z.B. bei zu hoher Stromaufnahme des Netzteils. Zur Registrierung und Überwachung von Schutzfunktionen ist ein Power Supply Switch Controller 22 vorgesehen, der von einem DC Power Supply 23 mit 24 V Betriebsspannung versorgt wird. Das DC Power Supply wird mit einem Schlüsselschalter eingeschaltet. Der Switch Controller liefert eine Einschaltverzögerung von ca. 1 sec. Diese Zeit benötigt der Microcontroller zur Initialisierung. Die Betriebsspannung für den Shifter 40 wird also erst erreicht, wenn der Microcontroller einen definierten Zustand erreicht hat. Das schützt die Endstufe 50 vor extremen Bedingungen.

Nachdem nun das Master-Relay 21 durchgeschaltet hat, wird die Spannung über einen Gleichrichter 24 zu einem Relay 25 geführt, das einem Startwiderstand parallel geschaltet ist. Über den Startwiderstand werden die Filterkondensatoren 26 aufgeladen. Die Spannung der Filterkondensatoren 26 wird über einen Spannungsteiler 27 dem Relay 25 zugeführt. Das Relay 25 schaltet durch, wenn die angelegte Spannung einen bestimmten Wert erreicht hat. Der Startwiderstand wird dann durch das Relay 25 überbrückt und so die gleichgerichtete Spannung direkt den Filterkondensatoren 26 zugeführt. Das gewährleistet ein langsames Aufbauen der Versorgungsspannung für den Shifter 40 beim Einschalten des Generators. Die Einschaltspannung U(NT) wird dem Microcontroller 80 zurückgemeldet, so daß eine Ansteuerung des Shifters 40 erst erfolgt, wenn U(NT) den Nennwert erreicht hat.

Vor dem Gleichrichter 24 wird der Wechselstrom gemessen und dem Switch Controller 22 zugeführt. Bei zu großem Strom scließt der Switch Controller 22 das Master-Relay 21 und schützt dadurch den Generator vor Zerstörung. Gleichzeitig wird das Softstart-Relay 25 geschlossen, wodurch der Innenwiderstand des Hauptnetzteils 20 hochohmig wird.

Die Wechselspannung am Eingang des Full Bridge Gleichrichters 24 wird einem zweiten Gleichrichter 28 zugeführt, der eine 12-V-stabilisierte Spannung sowohl für die Treiberstufe des Zerhackers 40 als auch für die Treiber der Endstufentransistoren 50 liefert.

Das Master-Relay 21 wird auch vom Switch Controller 22 abgeschaltet, wenn die Temperatur unterhalb der Platine gemessen 75°C übersteigt.

Einen weiteren Schutz des Generators gegen Überlastung liefert die Messung des Stroms zum Ultraschallwandler am Ausgang der Anpassung 60. Der Microcontroller 80 kann in diesem Fall den Switch Controller 22 potentialfrei ansteuern und zum Abschalten des Master-Relays 21 bewegen. Ebenso wird bei jedem Microcontroller-Fehler der Switch Controller 22 mit einem galvanisch getrennten Signal zum Abschalten des Master-Relays 21 aktiviert.

In jedem Fall wird der Switch Controller 22 auch den Parallelwiderstand des Softstart-Relays 25 einschalten, um einen hochohmigen Innenwiderstand des Hauptnetzteils 20 zu bekommen.

Ein mit 12 V stabilisierter Spannung versorgter Gleichspannungswandler 29 integriert die von der Endstufe 50 kommenden Impulse und gibt an den Microcontroller 80 eine potentialfreie Spannungsinformation weiter. Der Microcontroller erkennt anhand dieser Information, inwieweit sich die Spannung am Shifterausgang aufgebaut hat und kann im Bedarfsfall reagieren.

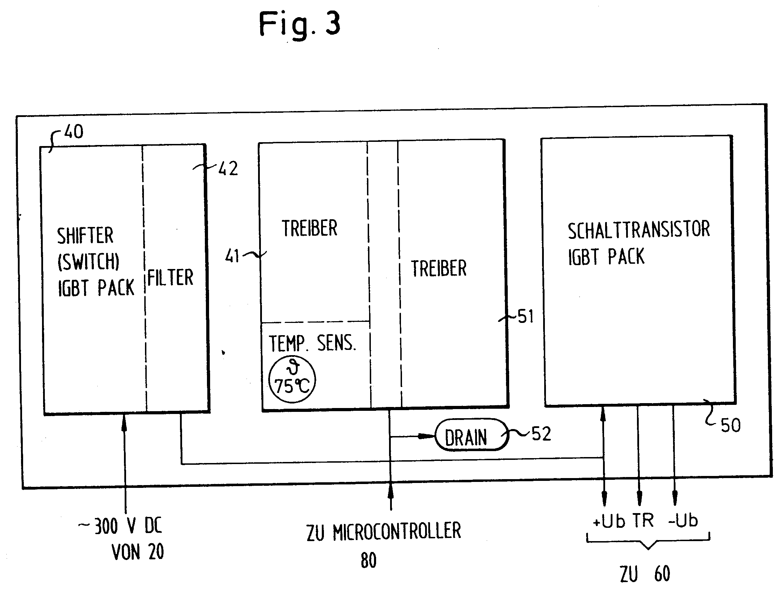

Wie in Fig. 3 dargstellt, besteht die Leistungsstufe aus drei Teilen, dem Shifter 40, der die ihm zugeleitete Spannung in Pulse zerhackt und in nicht dargestellten Kondensatoren wieder integriert, den Schalttransistoren 50 zur Erzeugung der Schwingfrequenz und der Treiberelektronik 41, 51, die sowohl die Schalttransistoren des Shifters 40 als auch die Halbbrücke des frequenzbestimmenden Teils treibt.

Der Microcontroller 80 bestimmt die Pulsbreite der Shifterimpulse und somit das nach dem Filter 42 abgegebene Spannungspotential, das wiederum die von der Halbbücke (Endstufe 50) an die Anpassung 60 abgegebene Leistung bestimmt.

Das an der Halbbrücke anliegende Spannungspotential kann über einen Drain-Widerstand 52 vom Microcontroller aus gesteuert auf Masse gelegt werden. Dadurch kann die Halbbrücke im Bedarfsfall sehr schnell stromlos gemacht werden.

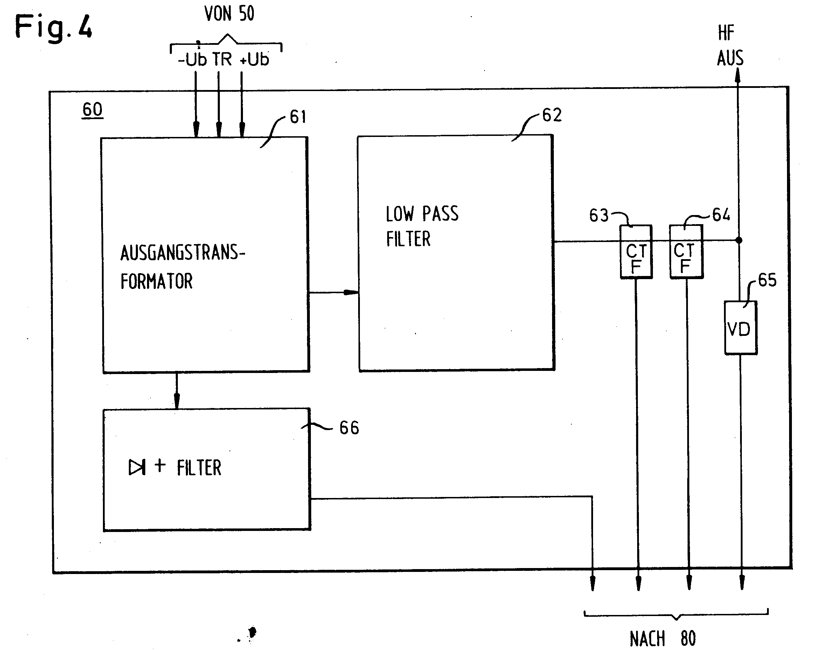

Die Anpassungsstufe 60 ist in Fig. 4 schematisch dargestellt. Sie setzt sich zusammen aus dem Ausgangstransformator 61 zur Anpassung der Impedanz an den Ultraschallwandler, dem Low Pass Filter 62 zur Umwandlung der Impulse in eine sinusförmige Schwingung und der Meßvorrichtung 63, 64, 65 für Strom und Spannung am Ausgang zum Ultraschallwandler. Der Strom des Stromwandlers 63 wird gleichgerichtet und dem Microcontroller 80 zugeführt. Der gleichgerichtete Strom als Funktion der Frequenz ist ein charakteristischer Kurvenverlauf, der das Schwingungsverhalten des Ultraschallwandler aufzeigt. Diese Information wird zur Einstellung der Regelparameter benötigt. Weiterhin wird über Spannungsteiler 65 die Wechselspannung an den Controller 80 geleitet, der die Phasendifferenz der beiden Meßgrößen Strom und Spannung zur Regelung des optimalen Arbeitspunktes während des Schweißprozesses benötigt.

Der Ausgangsstrom der Anpaßstufe 60 kann auch vom Stromwandler 64 als Wechselspannungssignal ausgegeben werden. Ferner kann über einen Gleichrichter und Filter 66 die Sekundärseite des Transformators 61 überwacht werden.

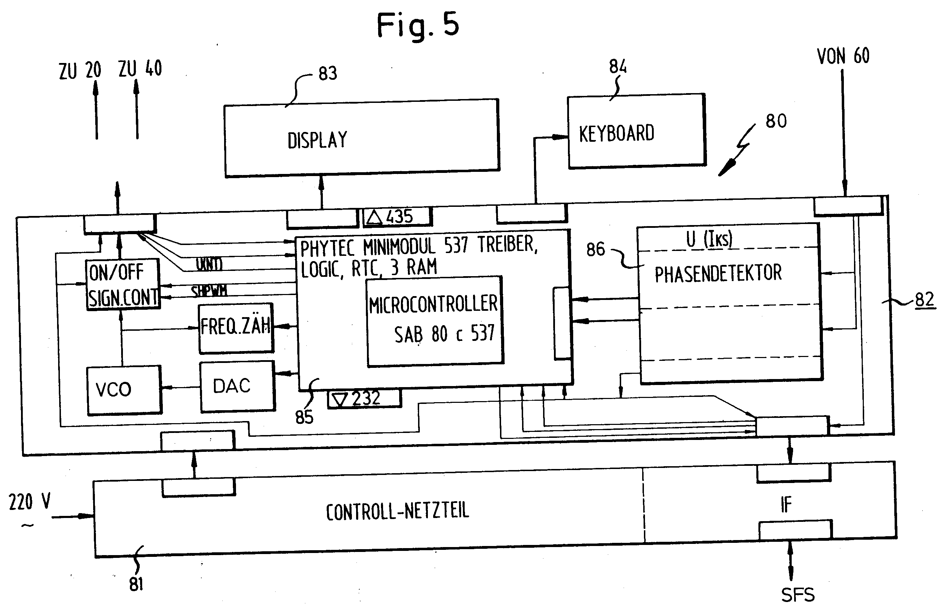

Alle wesentlichen Funktionen des Generators werden von einem Microcontroller 80 gesteuert und überwacht. Die einzelnen Funktionen sind in Fig. 5 dargestellt.

Der Microcontroller 80 besteht aus einem Netzteil 81 mit kundenspezifischen Signalausgängen, einer Controller-Platine 82, die den Microprozessor enthält, dem Display 83 und dem Keyboard 84. Das Controllernetzteil 81 liefert die Versorgungsspannung für die Controller-Platine 82 und das Display 84. Die Aus- und Eingangssignale zum Microprozessor werden über die Netzteilplatine 81 geschleift. Dazu zählen z.B. Überlast (Overload), Bereit (Ready), Ultraschall an (USON), Notaus (Ermergency off) und Trendsignale, die Trends einer Meßgröße in Richtung einer spezifizierten Grenze angeben. Die Signale Wandlerstrom größer als Nennwert und Hochfrequenz-Indikation werden nicht vom Microcontroller überwacht, sondern direkt auf einen Ausgang gegeben. Bei Überschreitung des Nennstroms tritt die Austastung des Master-Relays 21 im Hauptnetzteil 20 in Aktion.

Die HF-Indikation kann von einer externen Steuerung als Überwachungsgröße genutzt werden. Die Controller-Platine 82 besteht aus einem 8-Bit-Controller 85, der analoge Eingänge für folgende Informationen bietet:

Ein Spannungssignal U(IW), das proportional zum Wandlerstrom am HF-Ausgang ist.

Eine Spannung U(Phi), die proportional dem Betrag der Phase Phi ist und von einer Platine generiert wird, die die Phase zwischen Strom U(IW) und Spannung U(UW) am Ausgang zum Wandler mißt.

Der Phasendetektor 86 liefert auch eine Richtungsanzeige des Phasenwinkels, damit der Prozessor weiß, in welcher Richtung der Phasennulldurchgang zu suchen ist.

Ein Spannungssignal, das proportional zum alternierenden Strom am HF-Ausgang ist.

Ein Spannungssignal, das proportional zur alternierenden Spannung am HF-Ausgang ist.

Zwei Spannungssignale , die proportional der abgegebenen Wirk- bzw. Scheinleistung sind. Diese Signale entstammen einem Wattmeter.

Hier zeigt sich nun der eigentliche Vorteil des digitalen Generators. Die oben genannten Meßgrößen können einzeln oder in Gruppen oder alle zur Regelung des Generators eingesetzt werden. Die Regelung basiert auf einem Softwareprogramm, das die verschiedenen Regelgrößen nach Auswahl einsetzt. Diese Auswahl kann automatisch erfolgen oder nach Eingabe durch den Bediener.

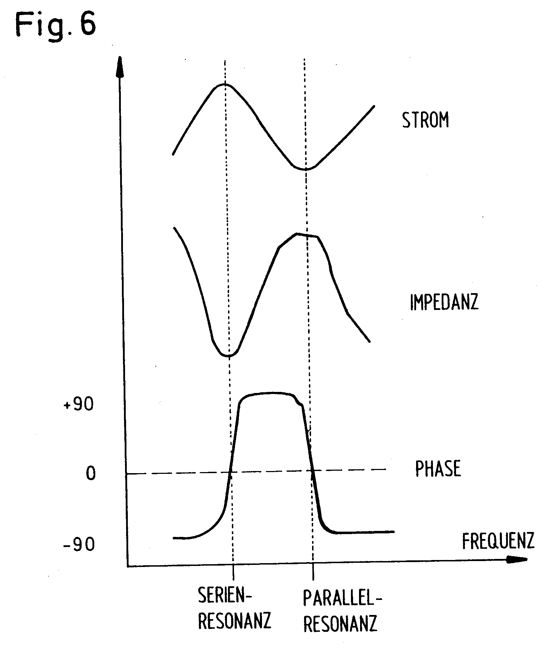

So ist zum Beispiel eine Regelung unter Einsatz des Stromes als Regelgröße möglich. Ultraschallwandler werden in der Regel in der Parallelresonanz der Impedanzkurve betrieben, wo der in den Wandler fließende Strom ein Minimum besitzt. Eine Regelung auf Stromminimum bietet sich demzufolge an. Allerdings hat sich gezeigt, daß diese Regelung auf das Stromminimum ungenau ist. Der Grund hierfür liegt in dem flachen Verlauf des Stromes als Funktion der Frequenz um den Resonanzpunkt herum. Fig. 6 zeigt den typischen Verlauf.

Fig. 6 zeigt zusätzlich den Verlauf der Impedanz als Funktion der Frequenz. Es wird deutlich, daß die Impedanzkurve ein Minimum und ein Maximum aufweist. Das Maximum entspricht der Parallelresonanz des Wandlersystems. Das Minimum stellt die Serienresonanz dar.

Eine wesentlich genauere Regelgröße ist der in Fig. 6 ebenfalls dargestellte Phasenverlauf. Er besitzt einen steilen Übergang von -90° nach +90°. Eine geringe Frequenzänderung bedeutet also eine große Änderung der Phase. Die Phase ist im Bereich des Resonanzpunktes sehr klein bzw. gleich Null. Das bedeutet physikalisch, daß Schein- und Wirkleistungsanteil gleich groß werden.

Die wesentlichen Vorteile der software-gesteuerten Regelung in Verbindung mit der speziellen Ausführung der Hardware werden nun deutlich:
1. Es können unterschiedliche Meßgrößen oder Kombinationen dieser Meßgrößen zur Regelung eingesetzt werden. Hier bietet sich zunächst die Phase wegen der hohen Genauigkeit als Regelgröße an. Allerdings kann die Phase jederzeit mit dem Strom, der Spannung, der Schein- oder Wirkleistung gekoppelt werden. Dadurch erhält die Regelung die Intelligenz zur Unterscheidung der Grundschwingung von Nebenresonanzen, die nicht erregt werden dürfen.
2. Vor dem Einsatz des Generators scannt die Software den Stromverlauf des Wandlers als Funktion der Frequenz über einen wählbaren Bereich. Die Information aus diesem Scan wird zur Berechnung des Abstandes zwischen Serien- und Parallelresonanz benutzt, die den Kopplungsfaktor des Systems bestimmt. In Abhängigkeit von diesem Abstand wird dann die Schrittweite der Frequenzänderung und die Meßzeit pro Frequenzmessung bei der Suche des Phasen-Nulldurchgangs und damit die Geschwindigkeit der Regelung festgelegt. Bei sehr steilem Übergang zwischen Serien- und Parallelresonanz wird die minimal mögliche Schrittweite gewählt, um den Nulldurchgang möglichst genau zu treffen. Bei sehr flachen Übergängen wird die Schrittweite größer gewählt, um möglichst schnell den Phasen-Nulldurchgang zu finden. Diese dynamische Anpassung der Frequnzauflösung adaptiert die Regelzeit an die akustischen Verhältnisse des Resonanzsystems. Weiterhin entnimmt die Software aus dem Stromspektrum den Wert der Parallelresonanz und hängt daran die Startfrequenz auf, von der aus der Phasen-Nulldurchgang ermittelt wird. Diese Startfrequenz liegt vorzugsweise soweit oberhalb der Parallelresonanz, daß nach Aufsetzen der Sonotrode und dadurch verursachtem Frequenzshift zu höheren Werten hin die Startfrequenz immer noch oberhalb der Parallelresonanz liegt. Beim ersten Schweißvorgang wird von dieser Frequenz aus gestartet. Bereits beim zweiten Schweißvorgang korrigiert die Software die Lage der Startfrequenz, die danach nur noch einige 10 Hz oberhalb der Parallelresonanz liegt, die sich im Kontaktfall ergibt. Dadurch ist die Zeit bis zur Findung des Phasennulldurchgangs minimiert. Ein weiterer wesentlicher Vorteil dieses Vefahrens ist die automatische Festlegung des Tune-Bereichs, wodurch zum einen ein manuelles Einstellen entfällt und zum anderen die Spezifikationsgrenzen für den zulässigen Frequenzbereich des Wandlersystems erheblich aufgeweitet werden können.
3. Die Regelung unterscheidet zwei Phasen, die Startphase und die Schweißphase. Die Startphase unterscheidet sich von der Schweißphase dadurch, daß die Schweißenergie stufenweise generiert wird bis zum maximalen Wert in der Schweißphase. Die Schrittweite und die Zeitdauer bis zur nächsten Stufe sind wählbar. Dadurch kann jede beliebige Anstiegsflanke erzeugt werden. Der Flankenanstieg ist von Bedeutung bei der Vermeidung von akustischem Stress in der Sonotrode. Die Regelung in der Startphase unterscheidet sich von der in der Schweißphase dadurch, daß hier ein Schwellenwert für den Phasenwinkel definiert wird, der bei Unterschreitung den Regelvorgang unterbricht und auf die nächste Energiestufe umschaltet. Dadurch wird der Regelvorgang beschleunigt, da die Phase nicht durch Null gehen muß. Diese Art der Regelung hat die höchste Stabilität im Anschwingverhalten gebracht, da hier ein schneller dynamischer Prozess abläuft, der eine schnelle Reaktionszeit erfordert. Da die Reaktionszeit sowohl durch die Schnelligkeit des Microcontrollers als auch die Auflösung im Frequenzbereicht festgelegt ist, konnte durch diese Methode den schnellen Frequenzänderungen der Resonanzfrequenz in der Anstiegsflanke des Schweißimpulses Rechnung getragen werden. Eine geringfügige Erhöhung der Scheinleistung wegen des nicht auf Null geregelten Phasenwinkels ist nicht von Bedeutung, da die Anstiegsflanke generell weniger als 20 % der Schweißzeit bedeutet.
4. Nach Erreichen der maximalen Schweißenergie schaltet dann die Regelung auf Phasen-Null-Durchgangsregelung um, um die geringste Scheinleistung bzw. den geringsten Blindstrom in der Ausgangsstufe zu gewährleisten. Der Phasen-Null-Durchgang wird durch das Richtungssignal definiert, das von der Phasenplatine zusammen mit dem Phasenbetrag geliefert wird. Diese schweißphasenabhängige Regelung ist nur mit Hilfe einer softwaregesteuerten Regelung möglich.
5. Es gibt auch bestimmte Ultraschallsysteme, die keinen Phasen-Null-Durchgang besitzen. Um bei solchen Systemen einen Null-Durchgang der Phase zu simulieren, ermittelt der Microcontroller 80 automatisch einen Phasen-Offset (Phasenverschiebung) und überprüft, ob weiterhin ein richtungsabhängiges Signal auftritt. Wenn sich das Vorzeichen des richtungsabhängigen Signals umkehrt, so ist ein Null-Durchgang der Phase simuliert. Auch wenn das Richtungssignal ausbleibt, schaltet der Controller 80 automatisch einen Phasen-Offset ein. Das Verfahren erlaubt damit, auch akustische Systeme zu betreiben, die von bekannten analogen Phasensteuerungen nicht mehr betrieben werden können.
6. Die Schwingungsamplitude gehört zu den signifikanten Parametern, die die Reißfestigkeit der Schweißnaht definieren. Der Generator bietet deshalb die Möglichkeit, die Amplitude während des Schweißprozesses automatisch zu regeln oder aber ein Amplitudenprofil vorzugeben. Diese Amplitudensteuerung oder Regelung geschieht durch Ansteuern des Shifters. Damit ist die Einbindung des Generators in eine kontinuierlich arbeitende Prozeßsteuerung möglich, die die Qualität der Schweißnaht mit den signifikanten Parametern korreliert.
7. Ein softwaregesteuerter Generator erlaubt weiterhin die optimale Anpassung an die Anwendung. Bei Inline-Systemen wie Verpackungsmaschinen erkennt die Software automatisch den Maschinentakt und stellt die Steuerung darauf ein. Ermöglicht wird das durch eine Erkennung des Aufsetzpunktes des Wandlers. Der Generator gibt eine feste Frequenz, die sogenannte Kontaktfrequenz, oberhalb der Parallelresonanz aus. Den Wert dieser Kontaktfrequenz bestimmt der Generator aus dem einmal ermittelten Stromspektrum. Die Amplitude ist sehr klein gehalten, um den Wandler vor unnötigem Stress zu schützen. Im Moment des Aufsetzens verschiebt sich die Resonanzfrequenz zu höheren Werten hin und passiert diesen eingestellten Frequenzwert. Die Phasenmessung zeigt deshalb für sehr kurze Zeit einen Phasensprung von 90° nach Null. Dieser Sprung wird detektiert und zeigt den Kontaktfall an. Danach setzt die Regelung wie oben beschrieben ein. Nach Beendigung der Schweißzeit wird wiederum die Festfrequenz oberhalb der Parallelresonanz bei kleiner Amplitude ausgegeben. Nach Beendigung der Haltezeit und Abheben der Sonotrode springt die Parallelresonanz wieder zum Ausgangspunkt zurück und passiert wiederum den festen Frequenzwert, diesmal von oben. Der Generator erkennt wiederum, daß die Sonotrode abgehoben hat und kann jetzt den Abstand zwischen den Schweißimpulsen und die Dauer der Schweißimpulse ermitteln und speichern. Um die Belastung des Generators minimal zu halten, wird die Kontaktfreuquenz oberhalb der Parallelresonanz nur einige 10 Millisekunden vor dem Aufsetzpunkt aktiviert und nachgeregelt, da geringe Schwankungen der Zyklusrate bei nicht SPS-gesteuerten Systemen möglich sind. Durch diese Intelligenz entfällt die Einspeisung und Einstellung eines Triggersignals. Außerdem gewährleistet diese Methode, daß nur dann Ultraschall eingebracht wird, wenn der Kontakt zum zu verschweißenden Material besteht. Dadurch wird unnötiger Stress in der Ausgangsstufe und der Sonotrode vermieden.
8. Der Abstand der Kontaktfrequenz zur Parallelresonanz im Leerlauf bestimmt die Kraft, bei der die Ultraschallenergie eingeleitet wird. Es ist nämlich die Aufsetzkraft von dem Abstand der Kontaktfrequenz zur Parallelresonanz im Leerlauf abhängig. Damit kann über die Wahl der Kontaktfrequenz die Aufsetzkraft und damit die Triggerkraft bestimmt werden, bei der die Leistungseinleitung erfolgen soll. Erfindungsgemäß entfällt dadurch der Einbau eines Kraftsensors zur Messung der Triggerkraft. Dies ist für solche Anwendungen von Bedeutung, die aufgrund der Bauteilegeometrie eine bestimmte Triggerkraft erfordern.
9. Durch Temperatureinfluß wird sich der Abstand der Kontaktfrequenz von der Parallelresonanz verändern. Um hier einen kostanten Abstand und damit konstante Triggerverhältnisse zu gewährleisten, wird die Kontaktfrequenz erfindungsgemäß durch Messung des Konverterstromes nachgeregelt. Der Konverterstrom ist minimal im Resonanzpunkt und ändert sich progressiv mit zunehmendem Abstand zum Resonanzpunkt.
10. Erheblichen akustischen Stress erfährt die Sonotrode bei Metallkontakt zum Amboss bei nicht vorhandenem bzw. bei Durchtrennung des Schweißgutes. Die analogen Generatoren besitzen hier keine Möglichkeit, den Metallkontakt zu erkennen und erzeugen auch in diesem Fall Ultraschallenergie. Der erfindungsgemäß softwaregesteuerte Generator kann den Metallkontakt durch den damit verbundene erheblichen Frequenzshift von mehreren hundert Hz durch Setzen eines Frequenzlimits erkennen und so eine Energieeinleitung verhindern.
11. Die softwaregesteuerte Regelung auf Phasen-Null-Durchgang zeigt kleinere Regelausschläge als die konventionelle spannungsrückgekoppelte Regelung. Die geringeren Regelschwankungen bedeuten im Mittel mehr Energiezufuhr in die Schweißnaht, da die Gesamtfläche auch bei gleicher Höhe des Schweißimpulses größer ist.
12. Spannungsschwankungen des Netzes kann der Generator durch die Ansteuerung ausregeln. Bricht das Netz z.B. um 10% zusammen, dann erkennt das der Generator anhand der abgegebenen Wirkleistung und macht den Shifter weiter auf, d.h. liefert mehr Energie in die Ausgangsstufe.
13. Ein weiterer Vorteil dieser Microcontrollersteuerung liegt in der Möglichkeit, während des Schweißprozesses externe Bedingungen an der Schweißpresse wie Druck, Weg etc online in den Schweißprozeß einzubeziehen, um die Qualität der Schweißnaht schon während des Schweißprozesses zu optimieren. Verfahren, die einen externen Controller einsetzen, können diese Parameter nur von Schweißung zu Schweißung steuern oder regeln.
14. Eine Konstanthaltung der an den Ultraschallwandler abgegebenen Leistung während des Schweißprozesses ist ebenso durch Regelung der vom Shifter erzeugten Impulsbreite möglich. Bei konstantem Druck entspricht das einer konstanten Schweißamplitude.
15. Die Software ermöglicht die automatische Auswahl der geeigneten Regelparameter. Sollte die Phasenregelung nicht in der Lage sein, trotz Phasen-Offset das vorliegende akustische System anzuregen, dann kann durch Setzen eines Flags im Eingabemenü der Generator auf Stromminimum-Regelung umgeschaltet werden. Damit werden Resonanzen angeregt, die ein Stromminimum aufweisen, unabhängig welcher Art diese Resonanzen sind. Prinzipiell ist der Generator damit nicht nur als Schweißgenerator einsetzbar, sondern auch für die Ultraschallreinigung. Die speziellen Anforderungen beim Ultraschallreinigen wie 100% ED, Frequenzsweep, Auffindung des geeigneten Resonanzpunktes und Modulation der Amplitude zur Entgasung der Reinigungsflüssigkeit können durch Modifikation der Software erreicht werden und sind vom Hauptmenü aus wählbar. Diese Liste der Vorteile zeigt, daß der Generator erfindungsgemäß durch seine Auslegung universell einsetzbar ist. Unterschiedliche Anwendungen bis hin zur Reinigung werden durch entsprechende Varianten erschlossen.

## Patentansprüche

1. Verfahren zum Betrieb eines Generators zur HF-Energieversorgung eines Ultraschallwandlers für dessen Betrieb in einem bestimmten Resonanzzustand, insbesondere zum Ultraschallschweißen, wobei der Phasenwinkel zwischen dem Strom und der Spannung am Ausgang des Generators gemessen und zur Frequenzregelung des Generators verwendet wird, indem eine dem Phasenwinkel zwischen Strom und Spannung proportionale Spannung erzeugt wird, und wobei zusätzlich zum Phasenwinkel der Strom, die Spannung und/oder die Schein- oder Wirkleistung am HF-Ausgang des Generators als zusätzliche Regelgrößen digital verarbeitet und mit dem Phasenwinkel digital verknüpft werden, um die gewünschte Resonanzfrequenz des Generators zu bestimmen, dadurch gekennzeichnet, daß zur Bestimmung des Resonanzzustandes des Wandlersystems der Stromverlauf im Ultraschallwandler als Funktion der Frequenz in einem wählbaren Bereich ermittelt wird, daß aus dem Abstand zwischen dem Strommaximum und dem Stromminimum die Frequenz für die Serien- und Parallelresonanz des Systems festgestellt wird und abhängig von diesem Frequenzabstand die Schrittweite der Frequenzänderung und damit die Regelgeschwindigkeit zum Auffinden des Phasen-Null-Durchganges bzw. des gegen Null gehenden Phasenwinkels bestimmt wird.

2. Verfahren nach Anspruch 1, dadurch gekennzeichnet, daß die Richtung des Phasenwinkelverlaufs in Bezug auf den Null-Durchgang des Phasenwinkels ermittelt wird.

3. Verfahren nach Anspruch 1, dadurch gekennzeichnet, daß für den Generator abhängig vom ermittelten Stromverlauf eine Startfrequenz eingestellt wird, die im Leerlauf des Generators sowie zu Beginn der Leistungsabgabe (nach Aufsetzen der Sonotrode) oberhalb der Parallelresonanzfrequenz liegt.

4. Verfahren nach Anspruch 3, dadurch gekennzeichnet, daß im Verlauf mehrerer Generatorstarts die Startfrequenz der Parallelresonanzfrequenz soweit angenähert wird, bis die Zeit zum Auffinden des Phasen-Nullgangs minimal ist.

5. Verfahren nach einem der Ansprüche 1 bis 4, dadurch gekennzeichnet, daß in einer Startphase des Generators die HF-Energie stufenweise bis zum maximalen Wert in der Leistungsphase generiert wird, wobei in der Startphase ein Schwellenwert für den Phasenwinkel bestimmt wird, bei dessen Unterschreiten auf die nächsthöhere Energiestufe umgeschaltet wird.

6. Verfahren nach Anspruch 5, dadurch gekennzeichnet, daß die Schrittweite und die Zeitdauer der einzelnen Energiestufen wählbar sind.

7. Verfahren nach Anspruch 5 oder 6, dadurch gekennzeichnet, daß nach Erreichen der maximalen Leistung die Regelung auf Phasen-Null-Durchgangsregelung umgeschaltet wird, in der die Regelung vom Phasenwinkel und dem zugehörigen Richtungssignal des Phasenwinkels bestimmt wird.

8. Verfahren nach Anspruch 5 oder 6, dadurch gekennzeichnet, daß bei fehlendem Phasen-Null-Durchgang des Systems dem Phasenwinkelsignal ein vorbestimmter Phasen-Offset aufgeschaltet wird, um einen Phasen-Null-Durchgang zu simulieren, und daß in Verbindung mit dem Phasenwinkel-Richtungssignal festgestellt wird, ob ein Phasen-Null-Durchgang erfolgt ist.

9. Verfahren nach einem der Ansprüche 1 bis 8, dadurch gekennzeichnet, daß die der Schwingungsamplitude der Sonotrode proportionale Spannungsamplitude am HF-Ausgang des Generators automatisch geregelt wird.

10. Verfahren nach Anspruch 9, dadurch gekennzeichnet, daß die Regelung entsprechend einem vorbestimmten Amplitudenprofil erfolgt.

11. Verfahren nach einem der Ansprüche 1 bis 10, dadurch gekennzeichnet, daß zum Erkennen des Aufsetzens des Ultraschallwandlers bzw. der Sonotrode auf ein Werkstück eine Kontaktfrequenz am Generator eingestellt wird, die so hoch gewählt wird, daß beim Aufsetzen die Resonanzfrequenz die eingestellte Kontaktfrequenz übersteigt, und daß der sich hierbei ergebende Phasensprung ermittelt wird, der den Aufsetzpunkt dann anzeigt.

12. Verfahren nach Anspruch 11, dadurch gekennzeichnet, daß zum Erkennen des Abhebens des Ultraschallwandlers bzw. der Sonotrode der Phasensprung ermittelt wird, der auftritt, wenn die Resonanzfrequenz unter die Kontaktfrequenz abfällt.

13. Verfahren nach Anspruch 11 oder 12, dadurch gekennzeichnet, daß aus den beim Aufsetzen oder Abheben auftretenden Phasensprüngen die Dauer der Leistungsphasen ermittelt und gegebenenfalls gespeichert wird.

14. Verfahren nach einem der Ansprüche 11 bis 13, dadurch gekennzeichnet, daß die Kraft, mit der die Ultraschallenergie in das Werkstück eingeleitet wird, abhängig vom Abstand ist, den die Kontaktfrequenz im Leerlauf des Generators von der Parallelresonanzfrequenz aufweist, so daß dieser Abstand ein Maß für die Kraft ist.

15. Verfahren nach einem der Ansprüche 11 bis 14, dadurch gekennzeichnet, daß zum Konstanthalten des temperaturabhängigen Abstandes der Kontaktfrequenz von der Parallelresonanzfrequenz die Kontaktfrequenz durch Messung des Konverterstroms nachgeregelt wird.

16. Verfahren nach einem der Ansprüche 1 bis 5, dadurch gekennzeichnet, daß bei einem Anstieg der Resonanzfrequenz über einen vorbestimmten Wert hinaus (Metallkontakt der Sonotrode) die Ultraschallenergie abgeschaltet wird.

17. Verfahren nach einem der Ansprüche 1 bis 16, dadurch gekennzeichnet, daß während der Leistungsphase des Generators weitere Regelgrößen, wie Druck, Weg für die Leistungsregelung verwendet werden und dadurch jeder Bearbeitungsvorgang jeweils individuell optimiert wird.

18. Verfahren nach einem der Ansprüche 1 bis 17, dadurch gekennzeichnet, daß die an den Ultraschallwandler abgegebene Leistung durch Regelung der Impulsbreite der vom Generator erzeugten Impulse konstant gehalten wird.

19. Verfahren nach einem der Ansprüche 1 bis 18, dadurch gekennzeichnet, daß der Generator auf Strom-Minimum-Regelung umgeschaltet wird, wenn das Ultraschallsystem von der Phasenwinkel-Regelung bzw. der Phasen-Null-Durchgangs-Regelung oder der Phasen-Offset-Regelung nicht anregbar ist.

20. Verfahren nach einem der Ansprüche 1 bis 19, dadurch gekennzeichnet, daß die Regelung von einem Microcontroller durchgeführt wird.

## Claims

1. A method for operating a generator supplying high frequency power to an ultrasonic transducer which is operated at a predetermined resonant frequency, in particular for ultrasonic welding, wherein the phase angle between the current and the voltage at the output of the generator is measured and utilized for frequency control of a generator by generating a voltage which is proportional to the phase angle between the voltage and the current, wherein in addition to the phase angle the current, the voltage and/or the apparent or the effective power at the high-frequency output of the generator are digitally processed to define supplemental control values which are digitally combined with said phase angle in order to determine a desired resonant frequency of the generator, characterized in that for determining the resonant condition of the transducer system the current wave form through the ultrasonic transducer is determined as a function of the frequency in a selected range, that the frequencies for the series and parallel resonance of the system are determined from the interval between the current maximum and the current minimum, and that in response to said frequency interval the incremental size of the frequency change and thus the control speed for discriminating a phase zero-crossing for a phase angle going towards zero is determinated.

2. The method of claim 1, characterized in that the direction of the phase angle wave form is determined with respect to the zero-crossing of the phase angle.

3. The method of claim 1, characterized in that a starting frequency for the generator is set in response to the current wave form determined which starting frequency is set to be above the parallel resonance frequency when the generator is in idle condition as well as when power delivery is initiated (after touch-down of the horn).

4. The method of claim 3, characterized in that the starting frequency is brought close to the parallel resonant frequency during a number of generator starts until the time period for discriminating the phase zero crossing is at a minimum.

5. The method of any of claims 1 to 4, characterized in that the high-frequency energy is generated in steps initiating from a start phase of the generator up to a maximum value in the welding phase, wherein during the start phase a threshold for the phase angle is determined for activating the next higher energy step when the phase angle drops below the threshold.

6. The method of claim 5, characterized in that the step size and the time period of the individual energy steps can be selected.

7. The method of claim 5 or 6, characterized in that after reaching the maximum power the control is switched to a phase zero-crossing control in which controlling is governed by the phase angle and the associated directional signal of the phase angle.

8. The method of claim 5 or 6, characterized in that a predetermined phase offset signal is provided to override the phase angle signal when the system lacks a phase zero-crossing to simulate a phase zero-crossing and that in combination with a phase angle directional signal it is determined whether or not a phase zero-crossing has occured.

9. The method of any of claims 1 to 8, characterized in that a voltage amplitude at the high frequency output of the generator being proportional to the oscillating amplitude of the horn is automatically controlled.

10. The method of claim 9, characterized in that the control is performed in following a predetermined amplitude profile.

11. The method of any of claims 1 to 10, characterized in that for discriminating a touch-down of the ultrasonic transducer or its horn onto a workpiece a touch-down frequency of the generator is adjusted which is selected to be a value such that in touch-down the resonant frequency exceeds the preset touch-down frequency and that the phase jump resulting therefrom is determined which indicates the touch-down.

12. The method of claim 11, characterized in that for discriminating the lifting of the ultrasonic transducer or its horn the phase jump is determined which occurs when the resonant frequency drops below the touch-down frequency.

13. The method of claim 11 or 12, characterized in that the time period of the welding phases is determined based on the phase jumps occurring on touch-down and lifting and stored, when necessary.

14. The method of any of claims 11 to 13, characterized in that the force of introducing the ultrasonic energy into the workpiece is a function of the interval between the touch-down frequency in the idle condition of the generator and the parallel resonant frequency, said interval being a measure for the force.

15. The method of any of claims 11 and 14, characterized in that the touch-down frequency is readjusted by measuring the converter current for maintaining the temperature responsive interval between the touch-down frequency and the parallel resonant frequency to be constant.

16. The method of any of claims 1 to 5, characterized in that the ultrasonic energy is interrupted when the resonant frequency increases above a predetermined value (metallic contact of the horn).

17. The method of any of claims 1 to 16, characterized in that during the welding phase of the generator further control quantities such as pressure and/or distance are utilized for power control to thereby individually optimizing each operation process.

18. The method of any of claims 1 to 17, characterized in that the power supplied to the ultrasonic transducer is held constant by controlling the pulse widths of the pulses generated by the generator.

19. The method of any of claims 1 to 18, characterized in that the generator is switched over to a current minimum control, when the ultrasonic system cannot be stimulated by the phase angle control or the phase zero-crossing control or the phase offset control.

20. The method of any of claims 1 to 19, characterized in that the controlling is performed using a micro-controller.

## Revendications

1. Procédé de mise en oeuvre d'un générateur servant à l'alimentation en énergie HF d'un convertisseur d'ultrasons pour faire fonctionner celui-ci dans un état de résonance déterminé, notamment pour le soudage aux ultrasons, le déphasage entre le courant et la tension à la sortie du générateur étant mesuré et utilisé pour la régulation de fréquence du générateur, par production d'une tension proportionnelle au déphasage entre le courant et la tension, tandis qu'outre le déphasage, le courant, la tension et/ou la puissance apparente ou la puissance effective à la sortie HF du générateur sont traités numériquement en tant que grandeurs supplémentaires de régulation et combinés numériquement au déphasage, en vue de déterminer la fréquence de résonance voulue du générateur, caractérisé en ce que, pour déterminer l'état de résonance du système convertisseur, la variation du courant dans le convertisseur d'ultrasons est relevée en fonction de la fréquence dans une plage pouvant être choisie, en ce qu'à partir de l'écart entre le maximum de courant et le minimum de courant, les fréquences correspondant à la résonance série et à la résonance parallèle du système sont établies et, en fonction de cet écart de fréquence, l'incrément de la variation de fréquence et donc la vitesse de régulation sont déterminés pour trouver le passage du déphasage par zéro, ou le déphasage s'approchant de zéro.

2. Procédé suivant la revendication 1, caractérisé en ce que le sens de la variation du déphasage est déterminé par rapport au passage du déphasage par zéro.

3. Procédé suivant la revendication 1, caractérisé en ce qu'une fréquence initiale est fixée pour le générateur en fonction de la variation de courant relevée, cette fréquence initiale étant située, en marche à vide du générateur et au début de la fourniture de puissance (une fois la sonotrode posée), au-dessus de la fréquence de résonance parallèle.

4. Procédé suivant la revendication 3, caractérisé en ce qu'au cours de plusieurs mises en marche du générateur, la fréquence de mise en marche est rapprochée de la fréquence de résonance parallèle jusqu'à ce que le temps nécessaire pour trouver le passage du déphasage par zéro soit minimal.

5. Procédé suivant l'une des revendications 1 à 4, caractérisé en ce que, dans une phase de mise en marche du générateur, l'énergie HF est produite du manière étagée jusqu'à la valeur maximale dans la phase de puissance, tandis qu'est déterminée, dans la phase de mise en marche, une valeur de seuil du déphasage pour le franchissement de laquelle vers le bas il est procédé à une commutation vers l'étage d'énergie directement supérieur.

6. Procédé suivant la revendication 5, caractérisé en ce que l'incrément et la durée des différents étages d'énergie peuvent être choisis.

7. Procédé suivant la revendication 5 ou 6, caractérisé en ce qu'une fois la puissance maximale atteinte, la régulation est commutée vers une régulation de passage du déphasage par zéro dans laquelle la régulation est déterminée par le déphasage et le signal de sens associé du déphasage.

8. Procédé suivant la revendication 5 ou 6, caractérisé en ce qu'en cas d'absence de passage du déphasage par zéro pour le système, un décalage de déphasage préfixé est introduit sur le signal de déphasage, pour simuler un passage du déphasage par zéro, et en ce qu'en liaison avec le signal de sens de déphasage, il est établi si un passage du déphasage par zéro a ou non eu lieu.

9. Procédé suivant l'une des revendications 1 à 8, caractérisé en ce que l'amplitude de tension, proportionnelle à l'amplitude d'oscillation de la sonotrode, sur la sortie HF du générateur fait l'objet d'une régulation automatique.

10. Procédé suivant la revendication 9, caractérisé en ce que la régulation a lieu conformément à un profil d'amplitude préfixé.

11. Procédé suivant l'une des revendications 1 à 10, caractérisé en ce que, pour constater la pose du convertisseur d'ultrasons ou de la sonotrode sur une pièce, une fréquence de contact est réglée sur le générateur, cette fréquence de contact étant choisie à un niveau tel que, lors de la pose, la fréquence de résonance dépasse la fréquence de contact réglée, et en ce que le saut de déphasage qui se produit alors est relevé, ce saut de déphasage indiquant alors l'instant de pose.

12. Procédé suivant la revendication 11, caractérisé en ce que, pour constater le soulèvement du convertisseur d'ultrasons ou de la sonotrode, le saut de déphasage qui a lieu lorsque la fréquence de résonance passe au-dessous de la fréquence de contact est relevé.

13. Procédé suivant la revendication 11 ou 12, caractérisé en ce qu'à partir des sauts de déphasage se produisant lors de la pose ou du soulèvement, la durée des phases de puissance est relevée et éventuellement conservée en mémoire.

14. Procédé suivant l'une des revendications 11 à 13, caractérisé en ce que la force avec laquelle l'énergie d'ultrasons est introduite dans la pièce dépend de l'écart que la fréquence de contact en marche à vide du générateur présente par rapport à la fréquence de résonance parallèle, de sorte que cet écart est une mesure pour la force.

15. Procédé suivant l'une des revendications 11 à 14, caractérisé en ce que, pour maintenir constant l'écart, dépendant de la température, de la fréquence de contact par rapport à la fréquence de résonance parallèle, la fréquence de contact fait l'objet d'un réglage après-coup au moyen d'une mesure du courant du convertisseur.

16. Procédé suivant l'une des revendications 1 à 5, caractérisé en ce que, lorsque la fréquence de résonance s'élève au-dessus d'une valeur préfixée (contact sur métal de la sonotrode), l'énergie des ultrasons est coupée.

17. Procédé suivant l'une des revendications 1 à 16, caractérisé en ce que, pendant la phase de puissance du générateur, d'autres grandeurs de régulation, telles que pression, voie pour la régulation de puissance, sont utilisées et, de ce fait, chaque opération d'usinage est rendue respectivement optimale d'une manière individuelle.

18. Procédé suivant l'une des revendications 1 à 17, caractérisé en ce que la puissance délivrée sur le convertisseur d'ultrasons est maintenue constante au moyen d'une régulation de la largeur d'impulsion des impulsions produites par le générateur.

19. Procédé suivant l'une des revendications 1 à 18, caractérisé en ce que le générateur est commuté sur une régulation de minimum de courant lorsque le système d'ultrasons ne peut pas être déclenché par la régulation de déphasage, ou la régulation de passage du déphasage par zéro, ou la régulation à décalage de déphasage.

20. Procédé suivant l'une des revendications 1 à 19, caractérisé en ce que la régulation est exécutée par un micro-contrôleur.
